# EUROPEAN PATENT SPECIFICATION

(11) **EP 1 617 529 B1**
(45) Date of publication and mention of the grant of the patent: **25.04.2007**
(21) Application number: 05014993.9
(22) Date of filing: 11.07.2005
(51) Int. Cl.: H01S 3/04

(54) **Laser unit comprising a circuit for cooling water**
Laser mit Kühlwassereinheit
Laser comprenant un circuit d'eau de refroidissement

(30) Priority: 14.07.2004 JP 2004207576; 15.10.2004 JP 2004301785
(43) Date of publication of application: 18.01.2006
(73) Proprietor: FANUC LTD, Minamitsuru-gun, Yamanashi 401-0597 (JP)
(72) Inventor: Nishikawa, Yuji, FANUC Manshonharimomi, Minamitsuru-gun, Yamanashi 401-0511 (JP); Yoshida, Hiroyuki, Gotenba-shi, Shizuoka 412-0042 (JP); Machida, Hisatada, FANUC Dai3virakaramatsu, Minamitsuru-gun, Yamanashi 401-0511 (JP); Nishio, Akihiko, FANUC Dai3virakaramatsu, Minamitsuru-gun, Yamanashi 401-0511 (JP); Miyata, Ryusuke, FANUC Manshonharimomi, Minamitsuru-gun, Yamanashi 401-0511 (JP)
(74) Representative: Schmidt, Steffen J.

(56) References cited:
- EP-A- 1 276 016
- PATENT ABSTRACTS OF JAPAN vol. 2002, no. 11, 6 November 2002 (2002-11-06) & JP 2002 190638 A (SHIBAURA MECHATRONICS CORP), 5 July 2002 (2002-07-05)
- PATENT ABSTRACTS OF JAPAN vol. 1995, no. 01, 28 February 1995 (1995-02-28) & JP 06 281389 A (MITSUBISHI ELECTRIC CORP), 7 October 1994 (1994-10-07)
- PATENT ABSTRACTS OF JAPAN vol. 2003, no. 12, 5 December 2003 (2003-12-05) & JP 2004 122038 A (ORION MACH CO LTD), 22 April 2004 (2004-04-22)
- PATENT ABSTRACTS OF JAPAN vol. 016, no. 108 (E-1179), 17 March 1992 (1992-03-17) & JP 03 283684 A (MITSUBISHI ELECTRIC CORP), 13 December 1991 (1991-12-13)
- PATENT ABSTRACTS OF JAPAN vol. 016, no. 397 (E-1252), 24 August 1992 (1992-08-24) & JP 04 130784 A (OLYMPUS OPTICAL CO LTD), 1 May 1992 (1992-05-01)
- PATENT ABSTRACTS OF JAPAN vol. 2002, no. 11, 6 November 2002 (2002-11-06) & JP 2002 198592 A (SHIBAURA MECHATRONICS CORP; TOSHIBA CORP), 12 July 2002 (2002-07-12)
- PATENT ABSTRACTS OF JAPAN vol. 018, no. 643 (E-1640), 7 December 1994 (1994-12-07) & JP 06 252472 A (ZEXEL CORP), 9 September 1994 (1994-09-09)

## Description

### BACKGROUND OF THE INVENTION

### 1. Field of the Invention

The present invention relates to a laser unit using circulating cooling water and, in particular, relates to a laser unit in which a way of control of the cooling water is improved.

### 2. Description of the Related Art

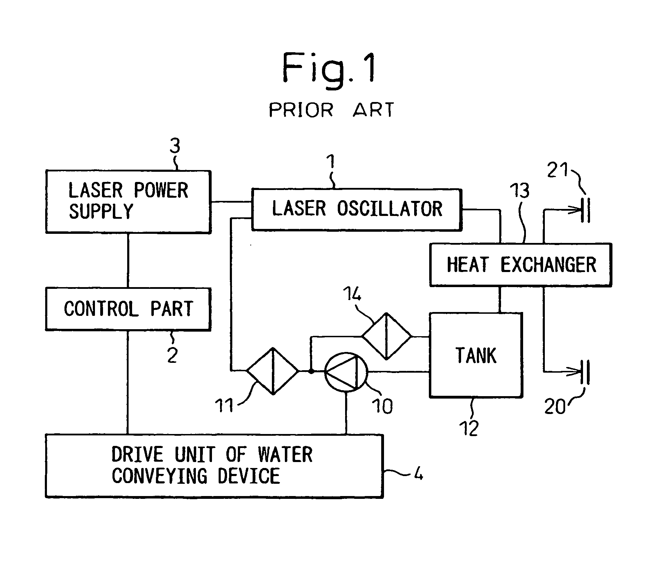

As is well known, circulating cooling water is used to avoid overheating, of a laser medium, which may occur during operation of a laser unit or during laser oscillation. Fig. 1 shows a schematic configuration of such a laser unit of the prior art. As shown, a laser oscillator 1 is a device for laser oscillation by receiving power from a laser power supply 3. The power supply 3 is controlled by a control part 2. The control part 2 sends a laser output command to the power supply 3 such that the laser oscillator 1 outputs the laser beam.

The output laser beam is used for laser machining, for example. When the control part 2 sends a laser stop command to the power supply 3, the laser oscillator 1 stops the laser oscillation to stop outputting the laser beam. At this point, the laser output command may include two type of commands, i.e., for a continuous oscillation and a pulse-like oscillation. In this specification, even in the latter case, the situation in which the pulse-like oscillation is being repeated is referred as "during laser oscillation". The control part 2 has a not shown manual operating part, such as an operating panel having a button, a display and a keyboard, arranged on the control part 2 in a known manner. Therefore, an operator may operate the control part 2 to output commands from the control part 2.

As is known, while the laser oscillator 1 outputs the laser beam, the gaseous or solid laser medium generates heat and the temperature of the medium and a peripheral member is raised. Therefore, the laser unit has a channel for cooling water (hereinafter called circulating cooling water) flowing within the laser oscillator 1. By circulating the cooling water in the channel, overheating of the laser medium and the peripheral member may be avoided and the temperature during laser oscillation may be made stable.

In order to pass the circulating cooling water, a water conveying device 10 is used. The water conveying device 10 is activated by a drive unit 4 controlled by the control part 2. The water conveying device 10 and the drive unit 4 are constituted, for example, by a combination of a pump and a drive inverter for the pump. The circulating cooling water is taken from a tank 12 and is delivered by the water conveying device 10. The delivered water is divided into two flows. The water of one of the flows is purified by passing through a filter 11 for the cooling water and flows into the laser oscillator 1. The water absorbs heat of the laser medium and the peripheral member, then, flows into a heat exchanger 13.

The circulating cooling water is returned to the tank 12 after the circulating cooling water is heat-exchanged with primary cooling water in the heat exchanger 13.

The primary cooling water is introduced into the laser unit from an inlet 20 and flows in a channel other than that of the circulating cooling water. Then, the primary cooling water is heat-exchanged with the circulating cooling water and flows out from the laser unit through an outlet 21. In other words, within the heat exchanger 13, channels for the circulating water and the primary cooling water separate from each other. The primary cooling water and the circulating cooling water do not mix.

On the other hand, the water of another flow different from the above two flows is returned to the tank 12, after metal ions in the water, etc. are removed by passing the flow through an ion-exchange resin 14. In this way, the circulating water may be circulated in a channel or a circuit.

It should be noted that, while the water conveying device 10 is running and the cooling water is circulating, the circulating water for cooling the laser oscillator 1 is purified by the filter 11 or the ion-exchange resin 14, however, when the device 10 is stopped, the circulating water is no longer purified and does not cool the laser oscillator 1.

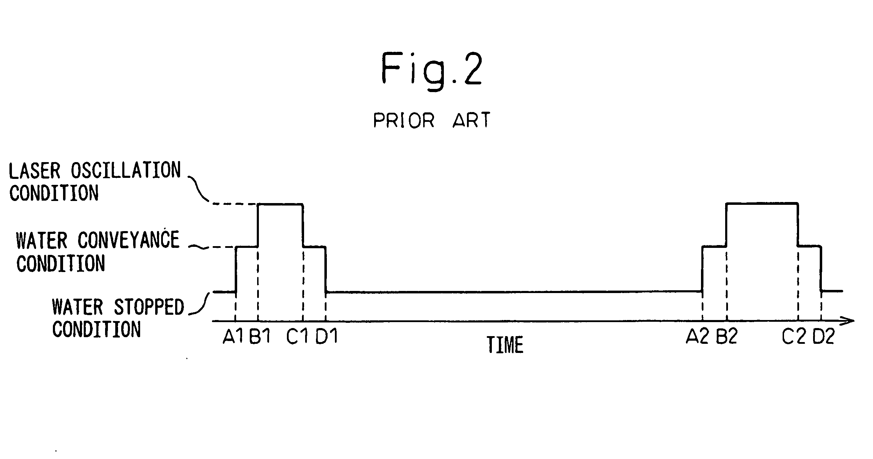

In operation of the laser unit employing such a cooling system, an operating procedure shown in Fig. 2 is used in prior art. First, before starting the laser unit, the water conveying device 10 is in a stop condition and the cooling water does not circulate (or is in a stopped condition). Starting from this condition, at time A1, the water conveying device 10 is activated by a command from the operator so as to circulate the cooling water (or change the condition to a conveyance condition). Next, the laser oscillation is started at time B1, by a command from the operator and is stopped, at time C1, by another command of the operator. Further, at time D1, the water conveying device 10 is also stopped by a command of the operator so as to stop circulating the cooling water (or return the condition to the stopped condition).

In many cases, the laser unit thus operated is no longer operated and, therefore, the cooling water is in the stopped condition until just before the next laser oscillation is started. After a time period from stopping to restarting of the circulation of the cooling water is passed, or at time A2, the water conveying device 10 is activated again by the command from the operator, whereby the cooling water circulates again. After that, at time B2, C2 and D2, the laser oscillation, the stop of the oscillation and the stop of the circulation of the water is carried out, respectively, as described above, resulting in the stopped condition.

Laser units as described above are known from JP-A-03 283 684.

The problem in this case is that, when the device 10 is stopped, the circulating water is no longer purified by the filter 11 or the ion-exchange resin 14 and does not cool the laser oscillator 1, as described above. Therefore, when a time period of the stopped condition is relatively long, mildew may appear on the filter 11 or the ion-exchange resin 14 and the bacteria may propagate in the still water, which may deteriorate the quality of the cooling water. When the laser oscillator is activated under a condition in which the quality of the cooling water is deteriorated, the laser output may be decreased.

So far, a simple technique, for economically avoiding the growth of mildew on the filter or the ion-exchange resin so as not to deteriorate the quality of the cooling water, has not been found in published documents.

### SUMMARY OF THE INVENTION

Accordingly, an object of the present invention is to provide a laser unit for economically avoiding the growth of mildew on the filter or the ion-exchange resin and the deterioration of the quality of the cooling water which may occur during an idle period of laser oscillation.

The present invention is intended to solve the above problems, by intermittently circulating the cooling water during the idle period of laser oscillation.

More specifically, the present invention provides a laser unit comprising: a circuit for cooling water for cooling a laser medium; a water conveying device for conveying the cooling water such that the cooling water circulates within the circuit; a control device for controlling the conveyance by the water conveying device; a purifying device, arranged in the circuit, for purifying the cooling water circulating in the circuit; wherein the control device controls the water conveying device, such that during a period of laser oscillation, the conveying device continuously conveys the cooling water; and during an idle period of laser oscillation, the conveying device intermittently conveys the cooling water so as to alternate between a conveyance condition in which the cooling water circulates in the circuit and a stopped condition in which the cooling water does not circulate in the circuit.

The laser unit may further comprise a heat exchanger arranged in the circuit and a channel for flowing primary cooling water heat-exchanged with the cooling water in the heat exchanger. From an economical point of view, it is preferable that the flow of the primary cooling water is stopped in the conveyance condition during the idle period of laser oscillation.

It is preferable that the water conveying device conveys the cooling water having one time to twenty times of the volume of a tank arranged in the circuit for the cooling water, within at most 48 hours, in the conveyance condition during the idle period of laser oscillation.

It is preferable that the purifying device is a particle filter having a mesh size equal to or less than 25 micrometer.

The water conveying device may be built into the body of the laser unit. Alternatively, the water conveying device may be located outside the body of the laser unit.

The stopped condition may be changed to the conveyance condition when a first predetermined period of time has passed from the beginning of the stopped condition. Also, the conveyance condition may be changed to the stopped condition when a second predetermined period of time has passed from the beginning of the conveyance condition.

The laser unit may further comprise a measuring device for measuring an electric conductivity of the cooling water and an ion-exchange resin arranged in the circuit for removing metal ions in the cooling water. In this case, it is preferable that the control device controls the water conveying device so as to control a flow rate passing through the ion-exchange resin such that the electric conductivity of the cooling water measured by the measuring device does not exceed a predetermined upper limit value. This upper limit value is advantageously equal to 3 micro-Siemens/cm.

### BRIEF DESCRIPTION OF THE DRAWINGS

The above and other objects, features and advantages of the present invention will be made more apparent by the following description of the preferred embodiments thereof, with reference to the accompanying drawings, wherein:
Fig. 1 a diagram showing an example of the configuration of a laser unit of prior art;
Fig. 2 is a diagram showing an operating procedure of the laser unit shown in Fig. 1;
Fig. 3 is a graph indicating the growth of bacteria during a conveyance-stop period and the decrease of bacteria after restarting the conveyance of water;
Fig. 4 is a graph indicating a change of a number of bacteria during the intermittent conveyance per day of the water;
Fig. 5 is a graph indicating a dependency of an asymptotic number of bacteria on a filter mesh size when the intermittent conveyance per day of the water is carried out for a long time;
Fig. 6 is a diagram showing an operating procedure of a laser unit in which the cooling water circulates during an idle period of laser oscillation;
Fig. 7 is a diagram showing a schematic configuration of a laser unit according to one embodiment of the invention;
Fig. 8 is a diagram showing a schematic configuration of a laser unit according to another embodiment of the invention;
Fig. 9 is a diagram showing an operating procedure of the laser unit shown in Fig. 7;
Fig. 10 is a flowchart for explaining a process of an intermittent conveyance mode of the embodiment of the invention; and
Fig. 11 is a diagram showing a schematic configuration of a laser unit according to still another embodiment of the invention, in which a water conveying device is located outside a body of the laser unit.

### DETAILED DESCRIPTIONS

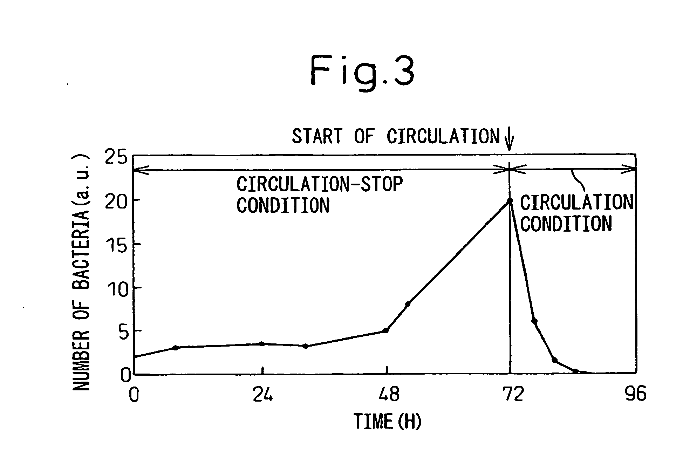

Fig. 3 is a graph indicating a relation between the number of bacteria and the circulation of the cooling water, concretely, an experimental result of the growth of bacteria when the cooling water does not circulate or the conveyance-stop period and a decrease of the bacteria after restarting the circulation of water. In this graph, an abscissa indicates a time after the conveyance of the cooling water is stopped and, an ordinate indicates the number of the bacteria per unit volume of the cooling water (a.u.). In other words, the graph indicates a change of the number of the bacteria detected by a microscopic examination. By the graph, the following points may be understood:
(1) The number of the bacteria increases from the stop of the conveyance of the water to the restart of the conveyance or after 72 hours.
(2) In particular, the number of the bacteria remarkably increases after 48 hours from the stop of the conveyance.
(3) The number of the bacteria decreases after the restart of the conveyance or the circulation of the cooling water.

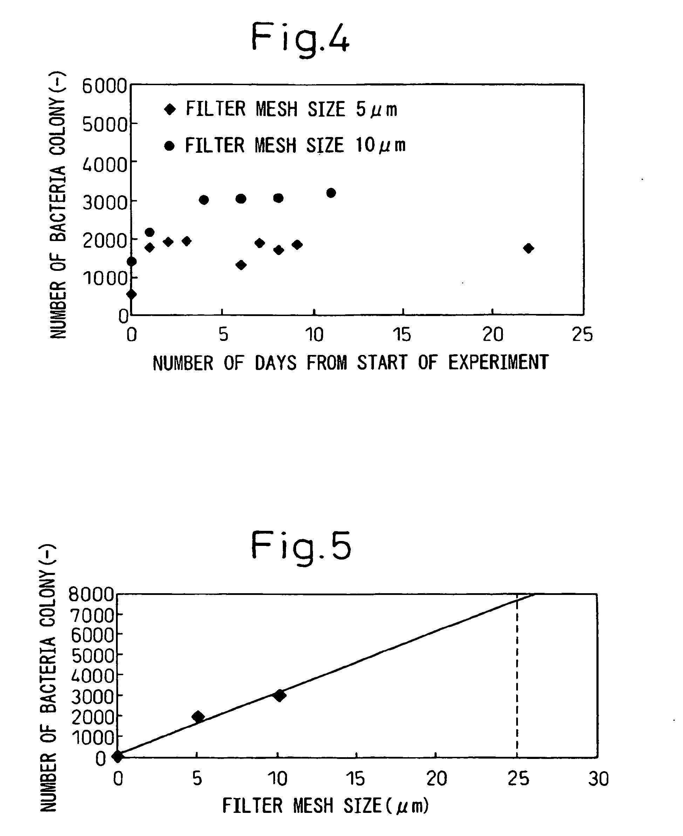

   Fig. 4 is a graph indicating an experimental result of a change of a number of bacteria in the laser unit. In the graph, an abscissa indicates a number of days from the start of the experiment and an ordinate indicates the number of the bacteria (counted as the number of colonies of the bacteria; hereinafter, the colony number is also used). In other words, the graph also indicates a change of the detected number of the bacteria. By the graph, the following points may be understood:
(4) When the conveyance is carried once time a day, the number of the bacteria reaches to a constant asymptotic number.
(5) The constant asymptotic number depends on a filter mesh size. As the mesh size is smaller (or the mesh is finer), the asymptotic number is lower.

As described above, when the conveyance is carried once time a day, the growth of the bacteria may be limited corresponding to the filter mesh size. In this regard, Fig. 5 shows a graph indicating a relation between the filter mesh size and the asymptotic number of the bacteria colony (or the number of the bacteria in a stationary state), when the conveyance is carried once time a day or intermittently.

In addition, it could be understood by the experiment that the number of the bacteria cannot be controlled when the number is larger than 8,000 per unit. That is, in a condition that the conveyance of the cooling water is carried once time a day, the above asymptotic number of the bacteria is difficult to find if the number of the bacteria colony exceeds 8,000 per unit. As shown in Fig. 5, the filter mesh size corresponding to "the bacteria number of 8,000 per unit" is 25 µm. In other words, in the condition that the conveyance is intermittently carried once time a day, the growth of the bacteria may be limited by using a filter having the mesh size less than 25 µm.

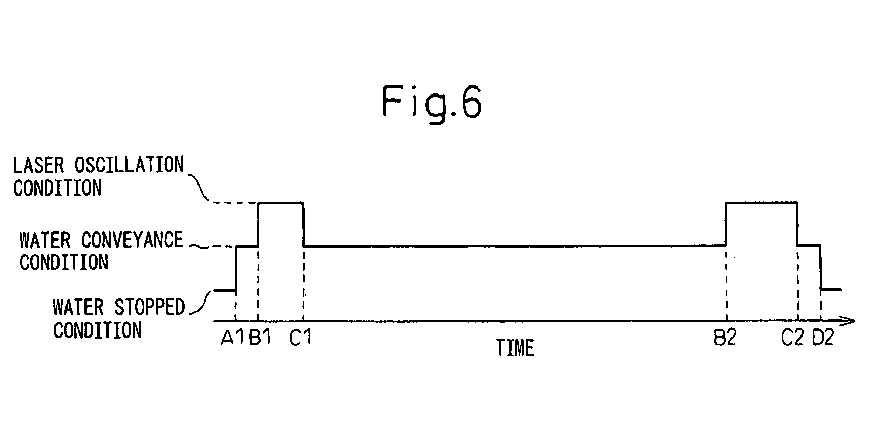

A simple way for avoiding the deterioration of the quality of the cooling water during the conveyance-stop period is a continuous circulation, by operating the water conveying device, even when the laser is not used. That is, as in a process shown in Fig. 6, when the cooling water always circulates, the quality of the cooling water may be kept in a good condition, whereby the growth of mildew on the filter or the ion-exchange resin may be avoided. However, this way is not obviously economic. Therefore, one embodiment in which the cooling water may be economically and suitably purified is described below.

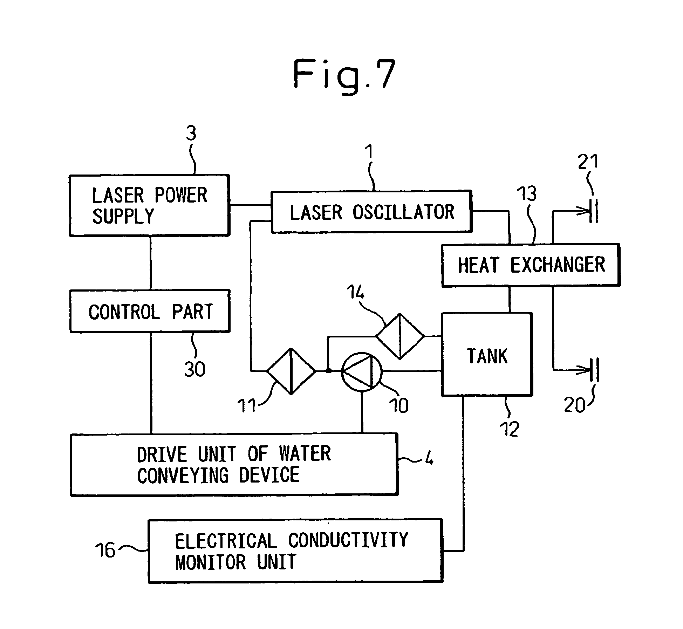

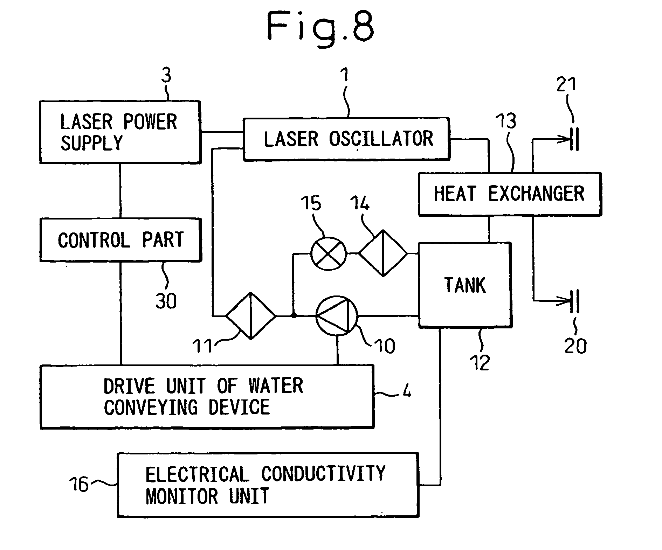

One embodiment according to the invention is described below, with reference to Figs. 7 - 10. The component which is the same as described in Fig. 1 is denoted by the same numeral as in Fig. 1 and, the repeated description of the component is properly omitted.

In Fig. 7, a schematic configuration of a laser unit according one embodiment of the invention is shown. In comparison Fig. 7 with Fig. 1, it is obvious that the configuration of the laser unit may be the same as a conventional laser unit. However, a control part 30 is used instead of the control part 2 in Fig. 1, as the content of controlling the water conveying device 10 is different, as described below.

That is, a laser oscillator 1 is a device for oscillating a laser beam by receiving a power by a laser power supply 3. The power supply 3 is controlled by a control device or a control part 30. The control part 30 sends a laser output command to the power supply 3 such that the laser oscillator 1 oscillates and outputs the laser beam. The output laser beam is used for laser machining, for example.

When the control part 30 sends a laser stop command to the power supply 3, the laser oscillator 1 stops the laser oscillation to stop outputting the laser beam. At this point, the laser output command may include two type of commands, i.e., for a continuous oscillation and a pulse-like oscillation. As described above, even in the latter case, the situation in which the pulse-like oscillation is being repeated is referred as "during laser oscillation". The control part 30 has a not shown manual operating part, such as an operating panel having a button, a display and a keyboard, arranged on the control part 30 in a known manner. Therefore, an operator may operate the control part 30 to output commands from the control part 30.

The laser unit has a channel, for cooling water flowing within the laser oscillator 1, in order to avoid overheating of the laser medium and a peripheral member. In order to pass the circulating cooling water, a water conveying device 10 is used, which is activated by a drive unit 4 controlled by the control part 30. The water conveying device 10 and the drive unit 4 are constituted, for example, by a combination of a pump and a drive inverter for the pump. The circulating cooling water is taken from a tank 12 and is delivered by the water conveying device 10. The delivered water is divided into two flows. As described with reference to Fig. 1, the water of one of the flows is purified by passing through a purifying device or a filter 11 for the cooling water and flows into the laser oscillator 1. The water absorbs heat of the laser medium and the peripheral member, then, flows into a heat exchanger 13.

The circulating cooling water is returned to the tank 12 after heat-exchanged with primary cooling water in the heat exchanger 13. As described above, the primary cooling water is introduced into the laser unit from an inlet 20, then, the water is heat-exchanged with the circulating cooling water and flows out from the laser unit through an outlet 21.

The water of the other flow of the above two flows is returned to the tank 12 after removed metal ions in the water, etc., by passing through an ion-exchange resin 14. The reason for removing metal ions is that all metal ions cannot dissolve in the cooling water when many metal ions are included in the water (or the electric conductivity of the water is high), whereby the metal ions may precipitate on the heat exchanger or the particle filter, resulting in the drop of the efficiency of heat exchange or the decrease of the flow rate of the cooling water by the constriction of the channel.

The drop of the efficiency of heat exchange may cause malfunction of the laser oscillator. Also, the decrease of the flow rate of the cooling water may change a suitable control time T1 previously calculated by using the flow rate. It has been found, by experiment, that the electric conductivity of the cooling water must be less than 3 µS/cm to permanently operate the system. As a simple way to suitably keep the electric conductivity, a monitor unit 16 for measuring the electric conductivity of the water and an alarm device for indicating when the measured value exceeds a predetermined threshold value less than 3 µS/cm, may be used.

Further, in order to suitably keep the quality of the water, an electromagnetic valve 15 may be positioned upstream or downstream of the ion-exchange resin 14. When the electric conductivity of the cooling water measured by the monitor unit 16 is larger than the predetermined threshold value, the electromagnetic valve 15 is opened to pass the water into the resin 14 so as to lower the electric conductivity. When the electric conductivity of the cooling water measured by the monitor unit 16 is less than the predetermined threshold value, the electromagnetic valve 15 is closed to not pass the water into the resin 14 and not to further lower the electric conductivity.

The cooling water thus flows and circulates in the channel of the circuit. Such a configuration is merely one example and may be variously changed. For example, the outlet 21 may be positioned on the circuit, or, the positions of the resin and the filter may be changed.

The ion-exchange resin and the particle filter are exemplary components included in a purifying means for the cooling water. Generally, other types of purifying means may be arranged. The heat exchanger also may have another constitution capable of heat exchanging with room air, instead of the constitution using the primary cooling water. Further, water conveying device may be positioned outside of the laser unit, as described below.

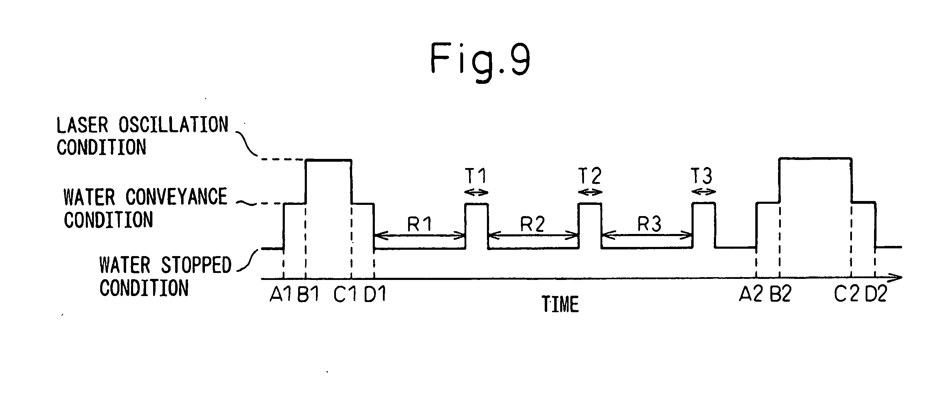

Next, an operation of the laser unit is described. Fig. 9 shows a time chart of an example of a procedure of the operation. The operation from time A1 to D1 may be the same as the described operation regarding prior art. For example, the water conveying device 10 is activated at time A1, by a command of the operator and, then, the laser oscillation is started at time B1. Next, the laser oscillation is stopped at time C1 and the water conveying device 10 is also stopped at time D1. After that, it is assumed that the laser oscillation is stopped for a considerably long time (for example, due to a summer vacation). In addition, it is economically advantageous to stop the flow of the primary cooling water in the channel when the laser oscillation is stopped.

The control part 30 activates a timer in the laser unit at this point or time D1. Then, after passing a predetermined period R1 less than 48 hours, the control part 30 outputs an operation command to the water conveying device 10 without receiving any command from the operator. On receiving the operation command, the water conveying device 10 automatically restarts conveying of the cooling water. At this point, the conveyance of the primary cooling water may be restarted.

As a matter of convenience, a j-th start command of automatic water conveyance during the idle period of the laser oscillation is called as "conveyance start command j". Therefore, at the first time (j = 1), "conveyance start command 1" is outputted.

After a period of time T1, required for the water conveying device to circulate the cooling water having a predetermined volume larger than one time and smaller than twenty times of the volume of the tank 12, the control part 30 outputs a stop command to the water conveying device 10 without receiving any command from the operator. If the primary cooling water is used, it is economically advantageous to stop the flow of the primary cooling water at the same time.

As a matter of convenience, a k-th stop command of automatic water conveyance during the idle period of the laser oscillation is called as "conveyance stop command k". Therefore, at the first time (k = 1), "conveyance stop command 1" is outputted.

One cycle including the start and stop of automatic water conveyance during the idle period of the laser oscillation is thus completed. After that, a sequence including the similar output command by the control part 30 is executed, without receiving any command from the operator. In other words, the sequence progresses as below: conveyance stop command 1 → passing of a period of time R2 → conveyance start command 2 → passing of a period of time T2 → conveyance stop command 2 → passing of a period of time R3 → conveyance start command 3 → passing of a period of time T3 → conveyance stop command 3 → ...

In the above example, after the conveyance stop command 3 is outputted, the operator manually inputs the conveyance start command to activate the water conveying device 10. In this case, the sequence is reset (or a timer within the control part 30 is reset). Then, at time B2, C2 and D2, the laser oscillation, the stop of the laser oscillation and the stop of the water conveying device are sequentially carried out, respectively, similarly to the above. After that, the timer within the control part 30 restarts and the above sequence for the idle period of the laser oscillation is restarted.

In this embodiment, when the water conveying device 10 is stopped according to the stop of the laser oscillation, the sequence for the idle period of the laser oscillation is executed such that the conveyance condition and the stopped condition are alternately repeated. This alternation is continued until the operator stops the sequence by, for example, an interrupt operation. Therefore, by suitably predetermining the parameters of the sequence R1, T1, R2, T2 ..., various disadvantages induced by the long idle period of the laser oscillation, such as the deterioration of the quality of the cooling water, may be avoided with a relatively small consumption energy.

The time parameters R1, R2, R3, R4 ... and T1, T2, T3, T4 ... used in the embodiment may be predetermined in various ways and, optimum values may be determined as design matters. As an exemplary way to simplify the sequence, R1 = R2 = R3 = R4 = ... = a constant value (a first constant period), T1 = T2 = T3 = T4 = ... = a constant value (a second constant period), or the combination thereof may be possible.

Further, taking into account the characteristic of the above change of the number of the bacteria, it is preferable that the time parameters R1, R2, R3, R4 ... and T1, T2, T3, T4 ... are determined such that the water conveying device conveys the cooling water having an equal volume to the volume of the tank 12, within at most 48 hours, even during the idle period of laser oscillation. At this point, the lower flow rate of the cooling water is preferable from an economical point of view. Further, the efficiency of limiting the growth of the bacteria is not raised when the flow rate is extremely high. In this sense, the flow rate of the cooling water substantially has an upper limit. As one benchmark for the upper limit, the conveyed volume per 48 hours, which is less than twenty times of the volume of the tank 12, is possible. Obviously, it is possible to adjust the conveyed volume by adjusting the power of the pump.

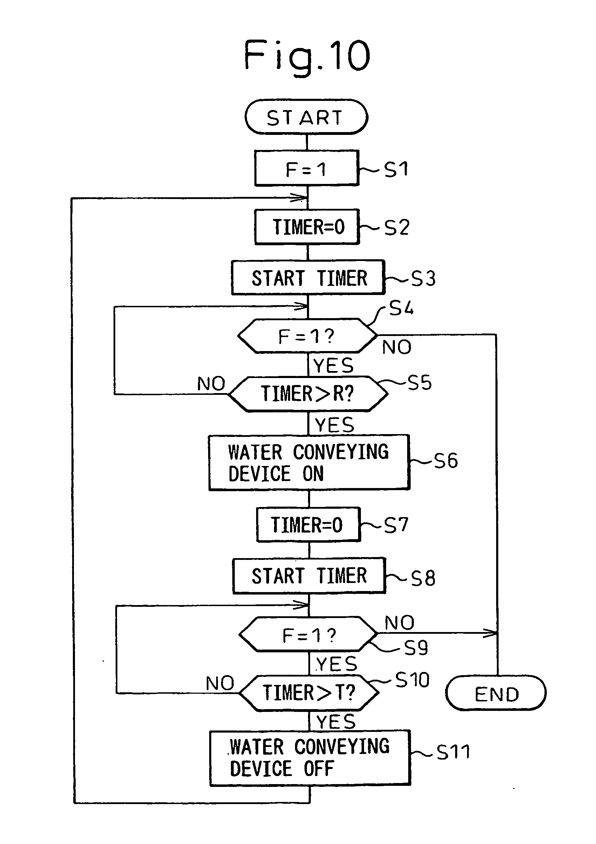

The values of the parameters R1, R2, R3, R4 ... and T1, T2, T3, T4 ... are previously inputted in a memory of the control part 30 and a sequence executing means of the control part 30 executes the sequence by using the values. A known control circuit, capable of executing such a sequence regarding the above time schedule, may be used as the sequence executing means. Alternatively, when the control part 30 includes a CPU, software for executing the above sequence may be used. One example of the sequence is shown in Fig. 10, where R1 = R2 = ... = R (the first constant period) and T1 = T2 = ... = T (the second constant period). The key point of operation at each step of the sequence is explained below.

The program for executing the sequence is activated every time when the operator manually inputs the conveyance stop command.

### Step S1

A flag F representing the automatic intermittent conveyance mode is set to "1" (i.e., the intermittent conveyance mode is valid).

### Step S2

The timer is cleared and set to zero.

### Step S3

The cleared timer is started.

### Step S4

The flag F is checked. If F = 1, the process progresses to step S5. If F = 0, the process is terminated. The flag F is changed to "0" (the intermittent conveyance mode is invalid) by a manual operation of the operator when the laser oscillation should be restarted.

### Step S5

It is checked whether the timer > R. If the timer > R, the process progresses to step S5. Otherwise, the process returns to step S4.

### Step S6

The water conveying device is activated to cause "the conveyance condition".

### Step S7

The timer is cleared.

### Step S8

The timer is started.

### Step S9

The flag F is checked. If F = 1, the process progresses to step S10. If F = 0, the process is terminated.

### Step S10

It is checked whether the timer > T. If the timer > T, the process is returned to step S2 after the water conveying device is stopped (Step S11). If the timer ≤ T, the process is returned to step S9.

The above sequence is repeated to intermittently convey the water, during, for example, night, week end or summer vacation, i.e., when the operation of the laser unit is stopped. Therefore, the deterioration of the quality of the water, the growth of the bacteria and/or the generation of mildew may be avoided or reduced. Further, the sequence requires less consumption of energy (normally, electric power) and thus is economically advantageous in comparison with a sequence in which the water conveying device 10 continuously runs.

When the operator changes the flag F from "1" to "0" after a vacation, for example, the change is recognized at succeeding step S4 or S9 and the laser unit is operated in a normal mode (i.e., the intermittent conveyance mode is invalid). Then, the normal operation of the laser unit including the laser oscillation and the conveyance of the cooling water is started by, for example, a manual input of the operator. After the normal operation ends and the operator stops the laser oscillation and the conveyance of the water, the program for executing the above sequence is started and the intermittent conveyance mode becomes valid (F = 1). This cycle is repeated.

Finally, a layout of devices regarding the conveyance of the water, particularly the water conveying device 10, will be briefly described. In the configuration shown in Fig. 7, the drive unit 4 for the water conveying device, the water conveying device 10, the filter 11 for the cooling water, the tank 12, the heat exchanger 13, the ion-exchange resin 14 and pipes for connecting them are arranged in the laser unit and the inlet 20 and the outlet 21 for the primary cooling water serve as the boundary between the laser unit and the outside thereof. The laser unit thus configured may be bulky. In particular, it may be convenient that the water conveying device 10 using a pump or the like is located outside of the body of the laser unit.

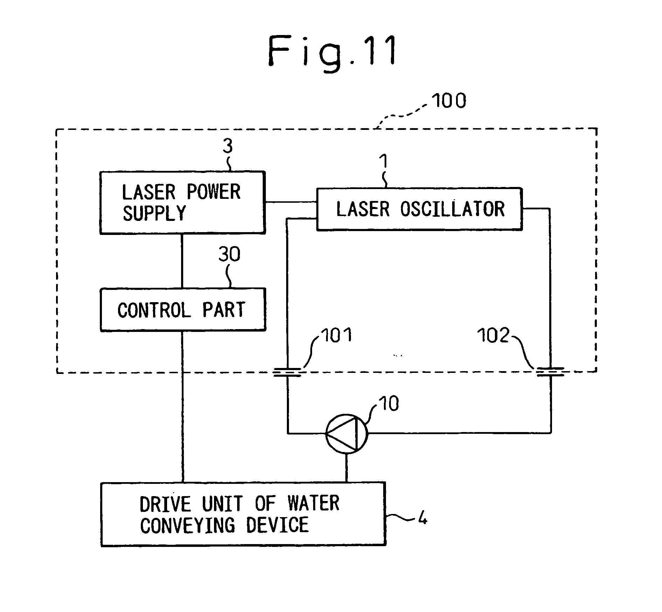

Fig. 11 shows an example in which the water conveying device is located outside. In Fig. 11, the boundary between the body of the laser unit and the outside thereof is indicated using a broken line. As shown, the drive unit 4 and the water conveying device 10 are located outside of the body of the laser unit 100(indicated by the broken line). An inlet 101 and an outlet 102 of the body of the laser unit are configured to allow the cooling water to flow into and from the channel in the body of the laser unit through the inlet 101 and the outlet 102.

Although the filter 11, the tank 12, the heat exchanger 13 and the ion-exchange resin 14 are not shown in Fig. 11, these components are also located outside of the body of the laser unit. The description of the operation including the intermittent conveyance is omitted as it is similar to the above example.

According to the laser unit of the present invention, the deterioration of the quality of the water, which may occur during the idle period of the laser oscillation, is avoided by intermittent conveyance of the water. Therefore, the reliability of the laser unit may be economically improved.

While the invention has been described with reference to specific embodiments chosen for the purpose of illustration, it should be apparent that numerous modifications could be made thereto, by one skilled in the art, without departing from the scope of the invention.

## Claims

1. A laser unit comprising:
a circuit for cooling water for cooling a laser medium;
a water conveying device (10) for conveying the cooling water such that the cooling water circulates within the circuit;
a control device (30) for controlling the conveyance by the water conveying device (10);
a purifying device (11), arranged in the circuit, for purifying the cooling water circulating in the circuit;
**characterized in that** the control device (30) controls the water conveying device (10), such that
during a period of laser oscillation, the conveying device (10) continuously conveys the cooling water; and
during an idle period of laser oscillation, the conveying device (10) intermittently conveys the cooling water so as to alternate between a conveyance condition in which the cooling water circulates in the circuit and a stopped condition in which the cooling water does not circulate in the circuit.

2. The laser unit as set forth in claim 1, further comprising a heat exchanger (13) arranged in the circuit and a channel for flowing primary cooling water heat-exchanged with the cooling water in the heat exchanger (13), wherein the flow of the primary cooling water is stopped in the conveyance condition during the idle period of laser oscillation.

3. The laser unit as set forth in claim 1, wherein the water conveying device (10) conveys the cooling water having one time to twenty times of the volume of a tank (12) arranged in the circuit for the cooling water, within at most 48 hours, in the conveyance condition during the idle period of laser oscillation.

4. The laser unit as set forth in claim 1, wherein the purifying device (11) is a particle filter having a mesh size equal to or less than 25 micrometer.

5. The laser unit as set forth in claim 1, wherein the water conveying device (10) is built into a body of the laser unit.

6. The laser unit as set forth in claim 1, wherein the water conveying device (10) is located outside a body of the laser unit.

7. The laser unit as set forth in claim 1, wherein the stopped condition is changed to the conveyance condition when a first predetermined period of time has passed from the beginning of the stopped condition.

8. The laser unit as set forth in claim 1, wherein the conveyance condition is changed to the stopped condition when a second predetermined period of time has passed from the beginning of the conveyance condition.

9. The laser unit as set forth in claim 1, further comprising a measuring device (16) for measuring an electric conductivity of the cooling water, and an ionexchange resin (14) arranged in the circuit for removing metal ions in the cooling water, wherein the control device (30) controls the water conveying device (10) so as to control a flow rate passing through the ionexchange resin (14) such that the electric conductivity of the cooling water measured by the measuring device (16) does not exceed a predetermined upper limit value.

10. The laser unit as set forth in claim 9, wherein the upper limit value is equal to 3 micro-Siemens/cm.

## Patentansprüche

1. Laser, umfassend:
einen Kühlwasserkreislauf zum Kühlen eines Lasermediums;
eine Wasserfördervorrichtung (10) zum Fördern des Kühlwassers derart, dass das Kühlwasser in dem Kreislauf zirkuliert;
eine Steuervorrichtung (30) zum Steuern der Förderung durch die Wasserfördervorrichtung (10);
eine Reinigungsvorrichtung (11), die in dem Kreislauf angeordnet ist, um das im Kreislauf zirkulierende Kühlwasser zu reinigen;
**dadurch gekennzeichnet, dass** die Steuervorrichtung (30) die Wasserfördervorrichtung (10) derart steuert, dass
während einer Periode der Laseroszillation die Fördervorrichtung (10) das Kühlwasser kontinuierlich fördert; und
während einer Ruhezeit der Laseroszillation die Fördervorrichtung das Kühlwasser intermittierend derart fördert, dass zwischen einem Förderzustand, in dem das Kühlwasser in dem Kreislauf zirkuliert, und einem Stoppzustand gewechselt wird, in dem das Kühlwasser in dem Kreislauf nicht zirkuliert.

2. Laser nach Anspruch 1, ferner umfassend einen Wärmetauscher (13), der in dem Kreislauf angeordnet ist, und eine Leitung zum Strömen lassen von Primärkühlwasser im Wärmetausch mit dem Kühlwasser im Wärmetauscher (13), wobei der Strom des Primärkühlwassers in dem Förderzustand während der Ruhezeit der Laseroszillation gestoppt ist.

3. Laser nach Anspruch 1, wobei die Wasserfördervorrichtung (10) das Kühlwasser, das das ein- bis zwanzigfache des Volumens eines in dem Kreislauf für das Kühlwasser angeordneten Tanks (12) aufweist, in dem Förderzustand während der Ruhezeit der Laseroszillation innerhalb von höchstens 48 Stunden fördert.

4. Laser nach Anspruch 1, wobei die Reinigungsvorrichtung (11) ein Partikelfilter mit einer Maschengröße gleich oder kleiner als 25 Mikrometer ist.

5. Laser nach Anspruch 1, wobei die Wasserfördervorrichtung (10) in ein Gehäuse des Lasers eingebaut ist.

6. Laser nach Anspruch 1, wobei die Wasserfördervorrichtung (10) außerhalb eines Gehäuses des Lasers angeordnet ist.

7. Laser nach Anspruch 1, wobei von dem Stoppzustand zu dem Förderzustand gewechselt wird, wenn eine erste vorbestimmte Zeitdauer seit dem Beginn des Stoppzustands verstrichen ist.

8. Laser nach Anspruch 1, wobei von dem Förderzustand zu dem Stoppzustand gewechselt wird, wenn eine zweite vorbestimmte Zeitdauer seit dem Beginn des Förderzustands verstrichen ist.

9. Laser nach Anspruch 1, ferner umfassend eine Messvorrichtung (16) zum Messen einer elektrischen Leitfähigkeit des Kühlwassers und ein Ionentauscherharz in dem Kreislauf zum Entfernen von Metallionen aus dem Kühlwasser, wobei die Steuervorrichtung (30) die Wasserfördervorrichtung (10) steuert, um eine Flussrate durch das Ionentauscherharz (14) so zu steuern, dass die von der Messvorrichtung (16) gemessene elektrische Leitfähigkeit des Kühlwassers einen vorbestimmten oberen Grenzwert nicht überschreitet.

10. Laser nach Anspruch 9, wobei der obere Grenzwert gleich 3 Mikrosiemens/cm ist.

## Revendications

1. Unité laser comprenant :
un circuit pour refroidir l'eau afin de refroidir un support laser ;
un dispositif d'acheminement d'eau (10) pour acheminer l'eau de refroidissement de telle sorte que l'eau de refroidissement circule dans le circuit ;
un dispositif de commande (30) pour commander l'acheminement par le dispositif d'acheminement d'eau (10) ;
un dispositif de purification (11) disposé dans le circuit pour purifier l'eau de refroidissement circulant dans le circuit ;
**caractérisée en ce que** le dispositif de commande (30) commande le dispositif d'acheminement d'eau (10), de telle sorte que
pendant une période d'oscillations du laser, le dispositif d'acheminement (10) achemine en permanence l'eau de refroidissement ; et
pendant une période d'inactivité des oscillations du laser, le dispositif d'acheminement (10) achemine l'eau de refroidissement par intermittence afin d'alterner entre un état d'acheminement dans lequel l'eau de refroidissement circule dans le circuit et un état d'arrêt dans lequel l'eau de refroidissement ne circule pas dans le circuit.

2. Unité laser selon la revendication 1, comprenant en outre un échangeur de chaleur (13) disposé dans le circuit et une voie pour faire circuler de l'eau de refroidissement primaire ayant échangé la chaleur avec l'eau de refroidissement dans l'échangeur de chaleur (13), dans laquelle le flux d'eau de refroidissement primaire est arrêté dans l'état d'acheminement pendant la période d'inactivité des oscillations du laser.

3. Unité laser selon la revendication 1, dans laquelle le dispositif d'acheminement d'eau (10) achemine l'eau de refroidissement ayant entre une fois et vingt fois le volume d'un réservoir (12) placé dans le circuit pour l'eau de refroidissement, pendant au plus 48 heures, dans l'état d'acheminement pendant la période d'inactivité des oscillations du laser.

4. Unité laser selon la revendication 1, dans laquelle le dispositif de purification (11) est un filtre à particules dont la taille des mailles est inférieure ou égale à 25 micromètres.

5. Unité laser selon la revendication 1, dans laquelle le dispositif d'acheminement d'eau (10) est intégré à un corps de l'unité laser.

6. Unité laser selon la revendication 1, dans laquelle le dispositif d'acheminement d'eau (10) est situé à l'extérieur d'un corps de l'unité laser.

7. Unité laser selon la revendication 1, dans laquelle l'état d'arrêt passe à l'état d'acheminement lorsqu'une première période de temps prédéterminée s'est écoulée depuis le début de l'état d'arrêt.

8. Unité laser selon la revendication 1, dans laquelle l'état d'acheminement passe à l'état d'arrêt lorsqu'une deuxième période de temps prédéterminée s'est écoulée depuis le début de l'état d'acheminement.

9. Unité laser selon la revendication 1, comprenant en outre un dispositif de mesure (16) pour mesurer une conductivité électrique de l'eau de refroidissement, et une résine échangeuse d'ions (14) placée dans le circuit pour retirer les ions de métal dans l'eau de refroidissement, dans laquelle le dispositif de commande (30) commande le dispositif d'acheminement d'eau (10) afin de commander un débit traversant la résine échangeuse d'ions (14) de telle sorte que la conductivité électrique de l'eau de refroidissement mesurée par le dispositif de mesure (16) ne dépasse pas une valeur limite supérieure prédéterminée.

10. Unité laser selon la revendication 9, dans laquelle la valeur limite supérieure est égale à 3 micro-Siemens/cm.
